# EUROPÄISCHE PATENTANMELDUNG

(11) **EP 1 016 735 A1**
(43) Veröffentlichungstag der Anmeldung: **05.07.2000**
(21) Anmeldenummer: 98124762.0
(22) Anmeldetag: 28.12.1998
(51) Int. Cl.: C23C 14/02, C23C 16/02, C23C 4/02

(54) **Verfahren zum Beschichten eines Erzeugnisses**

(71) Anmelder: SIEMENS AKTIENGESELLSCHAFT, 80333 München (DE)
(72) Erfinder: Döpper, Gebhard, 45473 Mülheim (DE)

(57) **Zusammenfassung**

Die Erfindung betrifft ein Verfahren zum Beschichten eines Erzeugnisses (1), welches einen Grundkörper (2) mit einem Grundmaterial (2A) aufweist. Auf den Grundkörper (2) wird eine erste Beschichtung (3) mit einem ersten Beschichtungsmaterial (3A) und auf die erste Beschichtung (3) eine zweite Beschichtung (4) mit einem zweiten Beschichtungsmaterial (4A) aufgebracht. Der Grundkörper (2) wird vor Aufbringung der ersten Beschichtung mit Abrasivpartikeln (5) des ersten Beschichtungsmaterials (3A) und/oder die erste Beschichtung (3) vor Aufbringung der zweiten Beschichtung (4) mit Abrasivpartikeln (6) des zweiten Beschichtungsmaterials (4A) bestahlt.

## Beschreibung

Die Erfindung betrifft ein Verfahren zum Beschichten eines Erzeugnisses welches einen Grundkörper mit einem Grundmaterial aufweist, auf welchen Grundkörper eine Beschichtung oder mehrere Beschichtungen aufgebracht werden.

In dem Buch 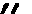 Plasma Spraying of Metallic and Ceramic Materials" von D. Matejka und B. Benko, John Willy and Sons, Chichester, U.K., 1989 ist das Verfahren des Plasmaspritzens mit Anwendungen beispielsweise auf Komponenten eines Verbrennungsmotors eines Kraftfahrzeuges angegeben. In Abschnitt 6.1 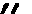 Preliminary preperation of surfaces prior to spraying" werden verschiedene Verfahren beschrieben, durch die eine Vorabbearbeitung eines zu beschichtenden Erzeugnisses erfolgt. Hierin ist ein Verfahren zur Reinigung der Oberfläche des Erzeugsnisses vor der eigentlichen Beschichtung mittels eines Strahles von abrasiv wirkenden Partikeln beschrieben. Die abrasiv wirkenden Partikel werden in einem Preßluftstrom mitgeführt und prallen vorzugsweise senkrecht auf die zu behandelnde Oberfläche auf. Die Bestrahlung mit den abrasiv wirkenden Partikeln kann in einer Kammer oder mit einer Saugeinrichtung durchgeführt werden, so daß im wesentlichen die gesamte Menge der abrasiv wirkenden Partikel wiedergewonnen und erneut für eine Bestrahlung zur Verfügung steht. Abrasiv wirkende Partikel können hierbei aus Gußeisen, Stahl, aus syntetischem Korund (Aluminiumoxid, Al₂O₃), Siliciumcarbid oder Silikatsand hergestellt werden. Die abrasiv wirkenden Partikel können einen Durchmesser zwischen 350 µm und 1400 µm aufweisen. Vorzugsweise wird die Bestrahlung mittels des sogenannten Grobsandstrahlens durchgeführt, wobei die abrasiven Partikel Korundpartikel mit einem Durchmesser zwischen 200µm und 800 µm sind und verwendet werden für die Vorbereitung einer Oberfläche mit einer Beschichtung mit einer Schichtdicke von bis zu 200 µm. Für Beschichtungen mit größerer Schichtdicke werden Partikeldurchmesser bis 1400 µm verwendet. Die Preßluft, in welcher die abrasiv wirkenden Partikel mitgeführt werden, hat bei der Verwendung von Korund vorzugsweise einen Druck von bis zu 0,35 MPa.

In der US-PS 4,321,310 ist ein Verfahren zur Herstellung einer Beschichtung auf einem Gasturbinenbauteil, einer Turbinenschaufel beschrieben. Die Turbinenschaufel weist einen Grundkörper aus einem Grundmaterial, einer Kobalt- oder Nickelbasislegierung, wie beispielsweise IN 100, MAR M200, MAR M509 oder WI 52 auf. Auf dieses Grundmaterial wird eine Haftvermittlerschicht der Art MCrAlY aufgebracht, wobei M beispielsweise für eine Kombination der Metallen Nickel und Kobalt steht. Cr steht für Chrom und Al für Aluminium sowie Y für Yttrium. Auf diese Haftvermittlerschicht wird eine keramische Schicht aus Zirkonoxid aufgebracht, die stengelförmig aufgewachsen ist, wobei die Stengel im wesentlichen senkrecht zur Oberfläche des Grundkörpers gerichtet sind. Vor Aufbringen der als Wärmedämmschicht dienenden Zirkonoxidschicht auf die Haftvermittlerschicht wird letztere poliert, so daß sie eine Oberflächenrauhigkeit von etwa 1 µm aufweist.

Die US-PS 5,683,825 betrifft ebenfalls ein Verfahren zum Aufbringen einer Wärmedämmschicht auf ein Bauteil einer Gasturbine. Auf einem Grundkörper wird durch Niederdruckplasmaspritzen eine NiCrAlY-Haftvermittlerschicht aufgebracht. Die Oberfläche der Haftvermittlerschicht wird poliert, so daß diese eine Oberflächenrauhigkeit von etwa 2 µm aufweist. Auf die so polierte Haftvermittlerschicht wird mittels eines Aufdamfverfahrens (PVD, Physical Vaper Diposition) eine keramische Wärmedämmschicht aus mit Yttrium stabilisierten Zirkonoxid aufgebracht. Vorzugsweise wird die Wärmedämmschicht hierbei mit dem sogenannten Elektronenstrahl-PVD-Verfahren aufgebracht. Die Wärmedämmschicht kann auch mittels Plasmaspritzens aufgebracht werden.

Gemäß der US-PS 5,498,484, welche ebenfalls das Aufbringen einer Wärmedämmschicht auf einer Haftvermittlerschicht eines Bauteils einer Gasturbine betrifft, beträgt die mittlere Oberflächenrauhigkeit der Haftvermittlerschicht zumindest über 10 µm.

Die US-PS 5,645,893 betrifft ein beschichtetes Bauteil mit einem Grundkörper aus einer Superlegierung, einer Haftvermittlerschicht und einer Wärmedämmschicht. Die Haftvermittlerschicht weist ein Platinaluminid sowie eine daran sich anschließende dünne Oxidschicht auf. Die dünne Oxidschicht weist Aluminiumoxid auf. An diese Oxidschicht grenzt die Wärmedämmschicht an, welche mittels dem Elektronenstrahl-PVD-Verfahren als mit Yttrium stabilisierte Zirkonoxidschicht aufgebracht wird. Vor Aufbringen der Haftvermittlerschicht wird die Oberfläche des Grundkörpers mittels eines Grobsandstrahl-Verfahrens gereinigt, wobei Aluminiumoxidsand verwendet wird.

In der WO 97/047781 A1 ist eine Gasturbinenkomponente, beispielsweise eine Gasturbinenschaufel oder ein Hitzeschildelement, beschrieben. Die Gasturbinenkomponente besteht aus einer Nickel- oder Kobaltbasissuperlegierung auf die eine Anbindungsschicht umfassend ein Nitrid aufgebracht ist. An die Anbindungsschicht schließt sich eine keramische Wärmedämmschicht an. Die Oberfläche der Anbindungsschicht weist eine mittlere Oberflächenrauhigkeit von über 6 µm, insbesondere zwischen 9 µm und 14 µm auf.

Aufgabe der Erfindung ist es ein Verfahren zum Beschichten eines Erzeugnisses, welches einen Grundkörper mit einem Grundmaterial aufweist anzugeben.

Erfindungsgemäß wird die Aufgabe dadurch gelöst, daß auf den Grundkörper eine erste Beschichtung mit einem ersten Beschichtungsmaterial und auf die erste Beschichtung eine zweite Beschichtung mit einem zweiten Beschichtungsmaterial aufgebracht werden, wobei vor Aufbringen der ersten Beschichtung der Grundkörper mit Abrasivpartikeln des ersten Beschichtungsmaterials und/oder vor Aufbringen der zweiten Beschichtung auf die erste Beschichtung, die erste Beschichtung mit Abrasivpartikeln des zweiten Beschichtungsmaterials bestrahlt werden bzw. wird.

Durch die Bestrahlung des Grundmaterials des Grundkörpers und/oder der Oberfläche der ersten Beschichtung mit jeweil gleichartigen Partikeln, d.h. Partikeln die aus dem gleichen Material bestehen, welches in dem Grundmaterial bzw. der ersten Beschichtung enthalten sind, können evtl. zurückbleibende Strahlmittelreste, z.B. nicht entfernte Abrasivpartikel, in das Grundmaterial oder eine der Beschichtungen eindiffundieren. Durch die Artgleichheit oder Artverwandtheit des Materials der Abrasivpartikel mit den Beschichtungen bzw. dem Grundkörper wird hierdurch eine Störung der Gefüge des Grundmaterials und der Beschichtungen vermieden. Mittels der Bestrahlung mit Abrasivpartikeln erfolgt zudem eine Glättung des Grundkörpers bzw. der ersten Beschichtung zur Einstellung einer vorgegebenen Rauhigkeit. Weiterhin kann durch das Bestrahlen mit Abrasivpartikeln eine Oberflächenreinigung durchgeführt werden, durch die eine Aktivierung der Oberfläche erreicht wird, so daß eine besonders gute Anbindung der ersten Beschichtung auf den Grundkörper bzw. der zweiten Beschichtung auf die erste Beschichtung erfolgt.

Für eine Oberflächenreinigung können hierbei die Abrasivpartikel einen Durchmesser von < 50 µm aufweisen und für eine Glättung einen Druchmesser von beispielsweise 100 µm aufweisen. Das Verfahren ist ebenfalls, insbesondere bei einem Erzeugnis, welches ein Bauteil einer thermischen Maschine ist, auch anwendbar wenn eine Beschichtung aus lediglich einer Schicht oder auch von mehr als zwei Schichten durchgeführt wird. Das Verfahren zeichnet sich hierbei aus, daß für die Bestrahlung Abrasivpartikel aus dem gleichen Material wie das Grundmaterial oder die Beschichtungsmaterialien verwendet werden.

Vorzugsweise ist das erste Beschichtungmaterial eine Legierung oder eine intermetallische Verbindung. Der Grundkörper ist ebenfalls vorzugsweise metallisch, insbesondere eine Nikkel-, Kobalt- oder Chromsuperlegierung. Die die erste Beschichtung, eine Haftvermittlerschicht bildende Legierung ist vorzugsweise der Art MCrAlX. Hierbei steht M für ein Metall, insbesondere ein Element der Gruppe umfassend Nickel, Kobalt und Eisen. Cr steht für Chrom und Al für Aluminium. X steht für eines oder mehrere Elemente aus der Gruppe Yttrium, Rhenium sowie einem Element der Seltenen Erden, wie beispielsweise Haffnium. Solche Legierungen sind beispielsweise in den obengannten US-Patenten angegeben.

Es ist ebenfalls möglich als erstes Beschichtungsmaterial für die Haftvermittlerschicht ein Aluminid, insbesondere Platinaluminid oder Nickelaluminid zu verwenden.

Die zweite Beschichtung ist vorzugsweise eine Keramik, insbesondere umfassend Zirkonoxid (ZrO₂) welches durch Yttriumoxid, Ceroxid oder ein anderes Oxid teil- oder vollstabilisiert sein kann. Eine solche, eine Keramik aufweisende zweite Beschichtung, ist vorzugsweise eine Wärmedämmschicht und weist als solche eine Schichtdicke von > 50 µm, insbesondere > 200 µm auf. Die Wärmedämmschicht kann auch ander metallkeramische Oxide, insbesondere auch metallkeramische Mischoxidsysteme, beispielsweise Perofskite(z.B. Lanthanaluminat), Pyrochlore (z.B. Lanthanhaffnat) oder Spinelle, wie beispielsweise das klassische Spinell MgAl₂O₄, aufweisen.

Das zu beschichtende Erzeugnis ist vorzugsweise einem heißen aggressiven Gas aussetzbar. Bevorzugt ist es ein Bauteil einer thermischen Maschine, wie beispielsweise einer Gasturbine, einem Verbrennungsmotor, einem Ofen oder ähnlichem. Die Temperaturen, welche das Erzeugnis während eines normalen Einsatzes ausgesetzt ist, können hierbei über 1000 °C liegen. Vorzugsweise ist das Erzeugnis eine Turbinenlaufschaufel, eine Turbinenleitschaufel oder ein Hitzeschildelement einer Brennkammer.

Die Abrasivartikel werden vorzugsweise in einem druckbeaufschlagten Trägermedium, wie z.B, einem Gas oder einer Flüssigkeit, bevorzugt Druck- oder Preßluft mitgeführt. Die Abrasivpartikel treffen vorzugsweise unter einem Winkel von 20° bis 90° insbesondere < 60°, auf eine Oberfläche des Erzeugnisses auf. Der Durchmesser der Abrasivpartikel, der Winkel zur Oberfläche des Bauteiles sowie der Druck des druckbeaufschlagten Trägermediums richten sich einerseits nach dem Material der Abrasivpartikel, dem Material der Oberfläche, auf der sie auftreffen, sowie der zu erzielenden Wirkung, insbesondere Oberflächenreinigung oder Materialabtrag, um eine Rauhigkeit einzustellen. Wird ein hoher Materialabtrag gewünscht, so ist der Winkel unter dem die Abrasivpartikel auf die Oberfläche auftreffen vorzugsweise > 50° bis 90°, insbesondere etwa 60°. Für eine Reinigung und Aktivierung der Oberfläche liegt der Winkel vorzugsweise in einem Bereich zwischen 20° und 60°.

Die Abrasivpartikel können in Form eines Pulvers bereitgestellt werden oder, falls größere Partikel vorliegen (globulare Form), durch einem Mahlprozeß zerrieben werden, um scharfkantige Partikel zu erzeugen, die dann verstärkt abrasiv wirken.

Anhand der in der Zeichnung dargestellten Ausführungsbeispiele wird das Verfahren näher erläutert. Es zeigen hierbei teilweise nicht maßstäblich und schematisch
- FIG 1: einen Ausschnitt eines Grundkörpers eines Erzeugnisses mit freier Oberfläche,
- FIG 2: einen Ausschnitt durch ein Erzeugnis bei dem auf einen Grundkörper eine erste Beschichtung aufgebracht ist,
- FIG 3: einen Ausschnitt durch ein Erzeugnis bei dem auf einen Grundkörper eine erste und eine zweite Beschichtung aufgebracht sind,
- FIG 4: eine Turbinenschaufel in perspektivischer Darstellung und
- FIG 5: ein Hitzeschildelement einer Brennkammer in perspektivischer Darstellung.

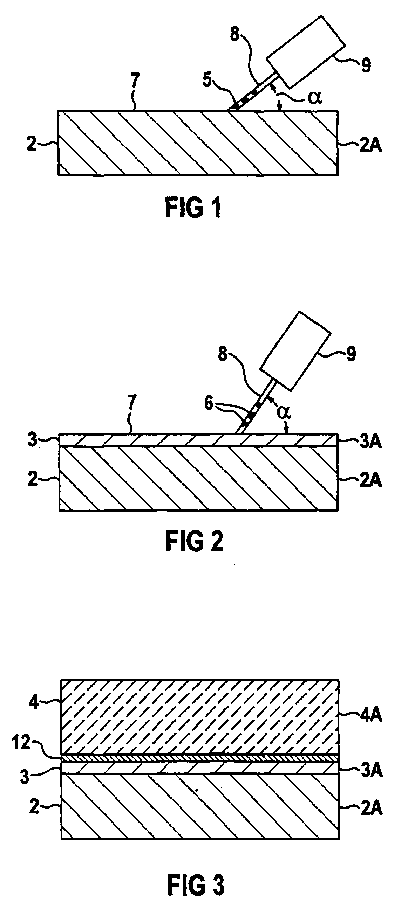

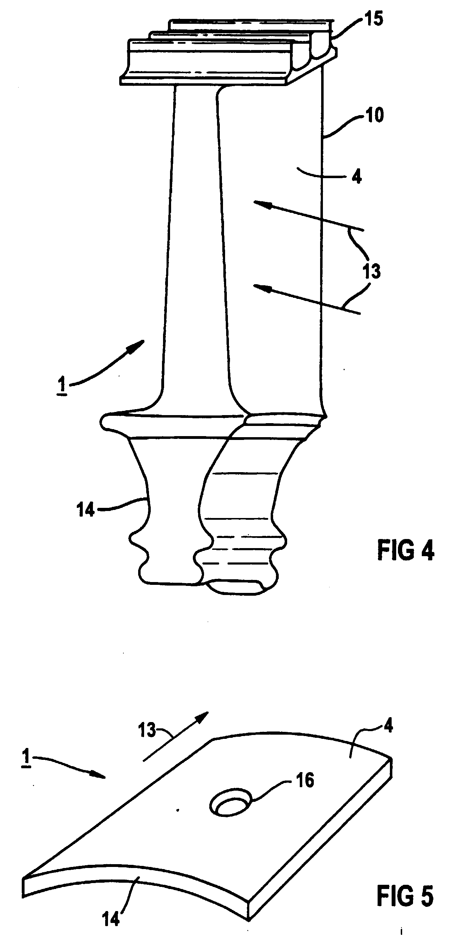

In FIG 1 ist ein Ausschnitt durch einen Grundkörper 2 eines nicht näher dargestellten Erzeugnisses 1 (siehe z.B. FIG 4 oder 5) mit einem Grundmaterial 2A, insbesondere einer Nickel- oder Kobaltsuperlegierung dargestellt. Der Grundkörper 2 weist eine Oberfläche 7 auf. Zur Vorbearbeitung vor Aufbringung einer Beschichtung (3, 4) wird die Oberfläche 7 mit Abrasivpartikeln 5 bestrahlt, die in einem druckbeaufschlagten Trägermedium 8, insbesondere Druckluft 8, mitgeführt werden. Zur Erzeugung eines solchen Strahls des Trägermedium 8 mit darin mitgeführten Abrasivpartikeln 5 ist ein Bestrahlungsapparat 9 vorgesehen. Die Abrasivpartikel 5, welche eine Glättung (Rauhigkeitsveränderung der Oberfläche 7) oder einer Reinigung mit Aktivierung der Oberfläche 7 dienen, treffen auf die Oberfläche 7 unter einem Winkel α in der Größenordnung zwischen 20° und 90°, insbesondere etwa 60°, auf. Die Abrasivpartikel 5 bestehen hierbei vorzugsweise aus dem Grundmaterial 2A oder aus einem Beschichtungsmaterial 3A, 4A, welches in der im Anschluß an die Bestrahlung mit den Abrasivpartikeln 5 auf den Grundkörper 2 aufzubringenden Beschichtung 3,4 enthalten ist.

In FIG 2 ist der Grundkörper 2 aus FIG 1 dargestellt, wobei auf diesen eine erste Beschichtung 3 mit einem ersten Beschichtungsmaterial 3A aufgebracht wurde. Die erste Beschichtung 3 ist vorzugsweise eine Haftvermittlerschicht und wurde mittels eines physikalischen Aufdampfverfahrens, beispielsweise Elektronenstrahldampfabscheidung (EB-PVD, Electron Beam Physical Vaper Diposition) oder einem Plasmaspritzen aufgebracht. Die erste Beschichtung 3 weist ein erstes Beschichtungsmaterial 3A auf, welches insbesondere beim Beschichten eines Gasturbinenbauteils eine Legierung der Art MCrAlX oder ein Aluminid ist. Durch die erste Beschichtung 3 ist nunmehr eine Oberfläche 7 des Erzeugnisses 1 an der dem Grundkörper 2 abgewandten Seite der Beschichtung 3 gebildet. Diese Oberfläche 7 wird nunmehr für das Aufbringen einer zweiten Beschichtung 4 vorbereitet. Hierzu wird die Oberfläche 7 mit Abrasivpartikeln 6 bestrahlt, die in einem Strahl aus einem druckbeaufschlagten Trägermedium 8 mitgeführt werden. Der Strahl des Trägermediums 8 wird in einem Bestrahlungsapparat 9 erzeugt, welcher der gleiche sein kann, wie bei der Bestrahlung des Grundkörpers 2. Die Abrasivpartikel 6 treffen auf die Oberfläche 7 unter einem Winkel α auf, welcher dem Winkel bei der Bestrahlung des Grundkörpers 2 gemäß FIG 1 entspricht oder von diesem abweicht. Die konkrete Wahl des Winkels, sowie des Druckes durch den das Trägermedium 8 beaufschlagt ist, hängen von der Art des Materials der Abrasivpartikel 6, der Art des ersten Beschichtungsmaterials 3A sowie beispielsweise noch von einer zu erzielenden Rauhigkeit oder Reinigung der Oberfläche 7 ab.

FIG 3 zeigt einen Ausschnitt durch das Erzeugnis 1, wobei auf den Grundkörper 2 neben der ersten Beschichtung 3 noch eine zweite Beschichtung 4 mit einem zweiten Beschichtungsmaterial 4A aufgebracht ist. Zwischen der zweiten Beschichtung 4, welche bei einem Bauteil einer Gasturbine vorzugsweise eine Wärmedämmschicht aus einem Metalloxid oder einem Metallmischoxidsystem ist, beispielsweise teil- oder vollstabilisiertes Zirkonoxid, ist eine Oxidschicht 12 angeordnet. Diese Oxidschicht 12 weist Aluminiumoxid und/oder Chromoxid auf und kann infolge thermischer Oxidation der ersten Beschichtung 3 gebildet worden sein (thermisch gewachsenes Oxid, TGO) oder wurde in einem Zwischenschritt auf die erste Beschichtung 3 aufgebracht.

FIG 4 zeigt in einer perspektivischen Ansicht ein Erzeugnis 1, hier eine Gasturbinenschaufel, welche einen Schaufelblattbereich 10 aufweist der mit einer Beschichtung 4, einer Wärmedämmschicht, beschichtet ist. Der Schaufelblattbereich 10 wird während des Einsatzes der Gasturbinenschaufel in einer nicht dargestellten Gasturbine von einem heißen aggressiven Gas 13, welches insbesondere durch Verbrennung eines Brennstoffes entsteht, umströmt. An den Schaufelblattbereich 10 grenzt einerseits ein Befestigungsbereich 14 an, in dem die Turbinenschaufel 1 in der Gasturbine befestigt ist und andererseits eine Deckplatte 15 an, die zur Abdichtung der Turbinenschaufel 1 gegenüber einer weiteren nicht dargestellten Komponente der Gasturbine dient.

In FIG 5 ist in einer perspektivischen Darstellung ein Erzeugnis 1, ein Hitzeschildelement, einer nicht dargestellten Brennkammer einer Gasturbine gezeigt. Das Hitzeschildelement 1 weist eine Auskleidungskomponente 17 mit einem zentrisch darin angeordneten Befestigungsloch 16 auf, durch welches ein nicht dargestelltes Befestigungselement führbar ist und das Hitzeschildelement 1 an einer nicht dargestellten Wand der Brennkammer befestigbar ist. Während eines Einsatzes des Hitzeschildelementes 1 ist dieses mit der Wärmedämmschicht 4 einem heißen aggressiven Gas 13 ausgesetzt.

Die Erfindung zeichnet sich dadurch aus, daß die Oberfläche eines Erzeugnisses vor Aufbringen einer Beschichtung mit abrasiv wirkenden Partikeln (Abrasivpartikel) bestrahlt wird, wodurch eine Glättung und/oder eine Reinigung mit Aktivierung der Oberfläche erzielt wird. Die Abrasivpartikel bestehen hierbei aus einem Material, welches in der auf den Grundkörper aufzubringenden Beschichtung enthalten oder in dem Grundkörper enthalten ist. Hierdurch können bei üblicherweise durchgeführten Diffusionswärmebehandlungen bei einem Heißgas aussetzbaren Bauteil, beispielsweise Gasturbinenschaufeln, evtl. durch die Bestrahlung mit den Abrasivpartikeln zurückbleibenden Strahlmittelreste in die aufzubringende Beschichtung oder das Grundmaterial des Grundkörpers eindiffundieren, wobei diese artgleichen Partikel ohne die Beschichtung oder das Grundmaterial zu beeinträchtigenderweise in das Gefüge eingebunden werden.

## Patentansprüche

1. Verfahren zum Beschichten eines Erzeugnisses (1), welches einen Grundkörper (2) mit einem Grundmaterial (2A) aufweist, wobei auf den Grundkörper (2) eine erste Beschichtung (3) mit einem ersten Beschichtungsmaterial (3A) und auf die erste Beschichtung (3) eine zweite Beschichtung (4) mit einem zweiten Beschichtungsmaterial (4A) aufgebracht wird, und der Grundkörper (2) mit Abrasivpartikeln (5) des ersten Beschichtungsmaterials (3A) und/oder die erste Beschichtung (3) mit Abrasivpartikeln () des zweiten Beschichtungsmaterials (4A) bestrahlt werden/wird.

2. Verfahren nach Anspruch 1, wobei als erstes Beschichtungsmaterial (3A) eine Legierung oder eine intermetallische Verbindung verwendet wird.

3. Verfahren nach Anspruch 2, bei dem eine Legierung der Art MCrAlX verwendet wird, wobei M für ein Metall, insbesondere der Gruppe umfassend Nickel, Kobalt und Eisen, Cr für Chrom, Al für Aluminiun und X für Yttrium, Rhenium und oder einem Element der seltenen Erden, wie Haffnium, steht.

4. Verfahren nach Anspruch 2, bei dem als erstes Beschichtungsmaterial (3A) ein Aluminid, insbesondere Platinaluminid (PtAl) oder Nickelaluiminid (NiAl), verwendet wird.

5. Verfahren nach einem der vorhergehenden Ansprüche,
bei dem als zweites Beschichtungsmaterial (4A) eine Keramik verwendet wird.

6. Verfahren nach Anspruch 5, bei dem als zweites Beschichtungsmaterial (4A) Zirkonoxid (ZrO₂) verwendet wird.

7. Verfahren nach einem der vorhergehenden Ansprüche, welches bei einem einem heißen aggressiven Gas (13) aussetzbaren Erzeugnis (1) angewendet wird.

8. Verfahren zum Beschichten eines Erzeugnisses (1), welches ein Bauteil einer thermischen Maschine, insbesondere einer Gasturbine, ist und einen Grundkörper (2) mit einem Grundmaterial (2A) aufweist, wobei eine Oberfläche (7) des Erzeugnisses (1)) mit Abrasivpartikeln (5,6) eines Beschichtungsmaterials (3A, 4A) bestrahlt und auf den Grundkörper (2) eine Beschichtung (3,4) mit dem Beschichtungsmaterial (3A, 4A) aufgebracht wird.

9. Verfahren nach einem der vorhergehenden Ansprüche, bei dem eine Beschichtung (4) als Wärmedämmschicht mit einer Schichtdicke größer 50 µm, insbesondere größer 200 µm, aufgebracht wird.

10. Verfahren nach Anspruch 9, wobei die Wärmedämmschicht (4) mit Yttriumoxid Y₂O₃ oder mit einem anderen Oxid der Seltenen Erden teil- oder vollstabilisiertes Zirkonoxid (ZrO₂) aufweist.

11. Verfahren nach einem der vorhergehenden Ansprüche, wobei als Erzeugnis (1) eine Turbinenlaufschaufel, eine Turbinenleitschaufel oder ein Hitzeschild eine Brennkammer verwendet wird.

12. Verfahren nach einem der vorhergehenden Ansprüche, wobei die Abrasivpartikel () unter einem Winkel von 20° bis 90°, insbesondere < 60°, auf eine Oberfläche (7) des Erzeugnisses (1) auftreffen.

13. Verfahren nach einem der vorhergehenden Ansprüche, bei dem die Abrasivpartikel (5, 6) in einem druckbeaufschlagten Trägermedium, insbesondere Pressluft, mitgeführt werden.
